(19) Europäisches Patentamt
European Patent Office
Office européen des brevets

(11) **EP 4 641 448 A1**

(12) **DEMANDE DE BREVET EUROPEEN**

(43) Date de publication:
**29.10.2025 Bulletin 2025/44**

(51) Classification Internationale des Brevets (IPC):
***G06N 3/0495*** *(2023.01)* ***G06N 3/063*** *(2023.01)*
***G11C 11/54*** *(2006.01)*

(21) Numéro de dépôt: **25171162.8**

(22) Date de dépôt: **17.04.2025**

(52) Classification Coopérative des Brevets (CPC):
**G06N 3/063; G06N 3/0495;** G11C 11/54

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **25.04.2024 FR 2404299**

(71) Demandeur: **Commissariat à l'Energie Atomique
et aux Energies
Alternatives
75015 Paris (FR)**

(72) Inventeurs:
• **GUICQUERO, William
38054 GRENOBLE CEDEX 09 (FR)**
• **PELLETIER, Nicolas
38054 GRENOBLE CEDEX 09 (FR)**

(74) Mandataire: **Cabinet Beaumont
4, Place Robert Schuman
B.P. 1529
38025 Grenoble Cedex 1 (FR)**

(54) **RESEAU DE NEURONES BINAIRES**

(57) La présente description concerne un circuit comprenant :
- un premier élément de mémoire configuré pour stocker une donnée ;
- un deuxième élément de mémoire configuré pour stocker une matrice de poids en association d'une couche d'un réseau de neurones binaires ;
- un circuit de calcul configuré pour :
a) recevoir la première donnée et la *k*-ème ligne de la matrice de poids ;
b) recevoir un premier signal de commande, indiquant la nature de chacune des première et deuxième fonctions de lecture chacune associée à une arithmétique à deux valeurs ;
c) générer un premier vecteur en appliquant la première fonction de lecture à la *k*-ème ligne de la matrice de poids et un deuxième vecteur en appliquant la deuxième fonction de lecture à la donnée ; et
d) générer une *k*-ième composante d'un premier vecteur de sortie sur la base des premier et deuxième vecteurs.

Fig. 2

**Description**

Domaine technique

La présente description concerne de façon générale les circuits configurés pour exécuter des réseaux de neurones binaires, et en particulier l'implémentation proche mémoire de tels réseaux.

Technique antérieure

Des opérateurs, tels que des produits scalaires, ou des produits d'Hadamard, interviennent généralement dans le fonctionnement de réseaux de neurones binaires. Ces opérateurs sont, par exemple, utilisés sur chaque couche du réseau et les sorties de l'opérateur sont binarisées, ou requantifiées.

Lorsque le réseau de neurones a, pour portage matériel, une architecture dite « proche mémoire », les opérateurs sont placés directement en sortie de mémoire, par exemple en bordure d'une tuile mémoire de type SRAM (de l'anglais "Static Random Access Memory"). De manière à économiser de la surface, il est souhaitable que le taux d'activité de ces opérateurs soit augmenté lors de l'exécution du réseau. De manière similaire, l'arithmétique utilisée, c'est à dire la définition de l'espace des nombres utiles, leurs relations et propriétés ainsi que les opérations mathématiques élémentaires réalisables, est la même pour toutes les couches du réseau.

De plus, certains réseaux intègrent des mécanismes de masquage (en anglais « gating ») de façon à favoriser l'émergence d'une contextualisation des traitements réalisés au sein du réseau (en anglais « attention-like mechanism »). Ces mécanismes sont généralement mis en œuvre par l'intermédiaire de fonctions d'activation travaillant de l'espace des nombres réels vers l'espace des nombres réels, telles que par exemple des fonctions de type softmax et/ou sigmoïde, suivies par un étage de multiplications point à point, couteux en surface du point de vue computationnel.

Il existe un besoin d'améliorer les architectures de réseaux de neurones binaires proche mémoire, notamment en termes de performance, de consommation d'énergie et de surface.

Résumé de l'invention

Un mode de réalisation prévoit un circuit comprenant :

- un premier élément de mémoire configuré pour stocker une première donnée ;
- un deuxième élément de mémoire configuré pour stocker une première matrice de poids en association d'une première couche d'un réseau de neurones binaires artificiel ;
- un circuit de calcul configuré pour :

  a) recevoir la première donnée et la $k$-ème ligne, de la première matrice de poids ;
  b) recevoir un premier signal de commande, indiquant la nature de chacune des première et deuxième fonctions de lecture, parmi au moins des première et deuxième fonctions de référence, les première et deuxième fonctions de référence étant chacune associée à une arithmétique à deux valeurs ;
  c) générer un premier vecteur en appliquant la première fonction de lecture à la $k$-ème ligne de la première matrice de poids et un deuxième vecteur en appliquant la deuxième fonction de lecture à la première donnée ; et
  d) générer une $k$-ième composante d'un premier vecteur de sortie sur la base des premier et deuxième vecteurs.

Selon un mode de réalisation, la première fonction de référence est à valeurs dans {-1,1} et la deuxième fonction de référence est à valeurs dans {0,1}.

Selon un mode de réalisation, le circuit ci-dessus est configuré pour, suite à la génération de la $k$-ième composante du premier vecteur de sortie, commander le stockage de la $k$-ième composante dans le premier élément de mémoire.

Selon un mode de réalisation, le circuit ci-dessus comprend en outre :

- une première porte logique configurée pour appliquer une opération de type AND entre la $k$-ième composante du premier vecteur de sortie, transmise par le circuit de calcul, et une composante d'un vecteur binaire ;
- une deuxième porte logique configurée pour appliquer une opération de type XNOR entre la $k$-ième composante du premier vecteur, transmise par le circuit de calcul, et la composante du vecteur binaire ;
- un premier multiplexeur configuré pour sélectionner la sortie de la première porte logique, ou la sortie de la deuxième porte logique, sur la base d'un signal de commande, indiquant la nature d'une troisième fonction de lecture parmi les première et deuxième fonctions de référence ;
- un deuxième multiplexeur configuré pour générer une $k$-ième composante d'un deuxième vecteur de sortie en sélectionnant la *k*-ième composante du premier vecteur, fournie par le circuit de calcul, ou la sortie du premier multiplexeur, sur la base d'un signal de modulation.

Selon un mode de réalisation, le circuit ci-dessus comprend en outre un circuit ordonnanceur configuré pour :

- recevoir une composante d'un vecteur stocké dans le premier élément mémoire ; et
- sur la base de la valeur de la composante, commander la lecture, dans le deuxième élément mémoire, de la *k*-ème ligne de la première matrice de poids.

Selon un mode de réalisation, le circuit de calcul comprend :

- un nombre *N* de circuits multiplieurs chacun configurés pour recevoir la première et la deuxième fonction de lecture et chacun configurés pour générer un scalaire de sortie sur la base d'une composante d'un vecteur et d'une composante d'une matrice de poids ;
- un circuit accumulateur configuré pour additionner les scalaires de sortie fournis par la pluralité de circuits multiplieurs ; et
- un convertisseur configuré pour convertir la valeur générée par le circuit accumulateur en une valeur binaire.

Selon un mode de réalisation, l'accumulateur comprend un arbre additionneur, comprenant une pluralité de circuits de décalage et configuré pour générer un scalaire, correspondant au produit scalaire entre les premier et deuxième vecteurs, augmenté d'un gain en puissance de 2.
Selon un mode de réalisation, la première donnée est de longueur *N*, *N* étant un nombre entier, et est stockée de manière contiguë par vecteurs de longueurs *K*, *K* étant un diviseur de la valeur *N*, et dans lequel la *k*-ème ligne, de la première matrice est de longueur *N* et dans lequel le circuit de calcul comprend un nombre *L = N/K* de registres à décalage reliés au premier élément de mémoire et est configuré pour, suite à la réception d'une suite de vecteurs de la première donnée, convertir ladite première donnée en un vecteur de taille *N*, par concaténation de vecteurs de taille *K*, dans lequel les registres à décalage sont, par exemple, en outre configuré pour effectuer la concaténation de la première donnée de taille *K* avec une suite de *N - K* bits chacun égaux à 1, ou à 0.
Selon un mode de réalisation, chacun des circuits multiplieurs comprend une porte logique de type NXOR et/ou AND configurée pour multiplier une composante de la première donnée et un élément de la première matrice de poids associé à la première couche.
Selon un mode de réalisation, le premier élément de mémoire est en outre configurée pour stocker un vecteur de masquage, le circuit ordonnanceur étant configuré pour :

- si la *k*-ième composante du vecteur de masquage est égale à 0, commander le stockage de la *k*-ième composante de la première donnée comme *k*-ième composante du premier vecteur de sortie ; et
- si la *k*-ième composante du vecteur de masquage est égale à 0, commander l'exécution des étapes a) à c).

Selon un mode de réalisation, le premier élément mémoire est une mémoire configurée pour la mise en œuvre d'opérations de masquages.
Selon un mode de réalisation, le deuxième élément de mémoire stocke en outre une troisième matrice de poids associée à une deuxième couche du réseau de neurones, et dans lequel le circuit de calcul est en outre configuré pour :

- sélectionner, suite à la réception d'un deuxième signal de commande, des cinquième et sixième fonctions de lecture, parmi les première et une deuxième fonctions de référence ;
- générer un cinquième vecteur en appliquant la cinquième fonction de lecture à une ligne, ou colonne, de la troisième matrice de poids et un sixième vecteur en appliquant la sixième fonction de lecture sur un vecteur de sortie d'une couche précédente, stockée dans le premier élément de mémoire ;
- générer une troisième valeur de sortie sur la base des cinquième et sixième vecteurs.

Selon un mode de réalisation, la première fonction de référence est définie par $g : u \to n$ et la deuxième fonction de référence est définie par $h : u \to 2u - 1$.
Un mode de réalisation prévoit un procédé comprenant :

- la fourniture d'une première donnée stockée dans un premier élément de mémoire d'un circuit et de la *k*-ème ligne d'une première matrice de poids associée à une couche d'un réseau de neurones artificiel binaire à un premier circuit de calcul du circuit ;
- la fourniture d'une indication, par l'intermédiaire d'un signal de commande, de la nature d'une première et d'une deuxième fonctions de lecture, parmi une première et une deuxième fonction de référence ;
- la génération, par le premier circuit de calcul, d'un premier vecteur en appliquant la première fonction à la *k*-ième ligne de la matrice de poids et d'un deuxième vecteur en appliquant la deuxième fonction sur la première donnée,
- la génération d'une k-ième composante d'un premier vecteur de sortie sur la base des premier et deuxième vecteurs, les première et deuxième fonctions de référence chacune associées à arithmétique à deux valeurs.

Selon un mode de réalisation, le premier circuit de calcul comprend une pluralité de circuits multiplieurs et un accumulateur configurés pour générer un scalaire en effectuant un produit scalaire entre les premier et deuxième vecteurs, dans lequel, le premier circuit de calcul comprend, par exemple, un convertisseur configuré pour convertir le scalaire en une valeur binaire.

Selon un mode de réalisation, le procédé ci-dessus comprend en outre :

- la lecture, par un deuxième circuit de calcul de la valeur d'une première composante de la première donnée, de la première valeur de sortie et d'une première valeur de masquage, stockées dans le premier élément mémoire ; et
- la commande, sur la base de la première valeur de masquage et par le deuxième circuit de calcul, de l'écriture d'une première valeur masquée, dans le premier élément mémoire, correspondant soit à la première composante de la première donnée, soit à la k-ième composante du premier vecteur de sortie.

Selon un mode de réalisation, l'écriture de la première valeur masquée comprend :

- la suppression de la première composante de la première donnée ; et
- l'écriture de la première valeur masquée à l'adresse de la première composante de la première donnée dans le premier élément mémoire.

Selon un mode de réalisation, le procédé ci-dessus comprend en outre, après l'écriture de la première valeur masquée :

- la génération d'une k+1-ième composante de sortie du premier vecteur de sortie et son stockage dans le premier élément mémoire ;
- la lecture, par le deuxième circuit de calcul de la valeur d'une k+1-ième composante de la première donnée, de la k+1-ième composante du premier vecteur de sortie et d'une deuxième valeur de masquage, stockées dans le premier élément mémoire ; et
- la commande, sur la base de la deuxième valeur de masquage et par le deuxième circuit de calcul, de l'écriture d'une deuxième valeur masquée, dans le premier élément mémoire, correspondant soit à la k+1_ième composante de la première donnée, soit à la k+1_ième composante du vecteur de sortie.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est un schéma par bloc illustrant un produit scalaire rebinarisé dans une couche d'un réseau de neurones ;

la figure 2 est un schéma par bloc illustrant un exemple d'architecture proche mémoire d'un réseau complètement connectée, selon un mode de réalisation de la présente description ;

la figure 3 est un schéma illustrant un exemple d'implémentation d'un opérateur de produit scalaire requantifié ;

la figure 4A est un schéma illustrant un exemple d'arbre additionneur, selon un mode de réalisation de la présente description ;

la figure 4B est un schéma illustrant un exemple d'un circuit de décalage de bits programmable de l'arbre additionneur de la figure 4A, selon un mode de réalisation de la présente description ;

la figure 5 est un schéma par bloc illustrant un produit scalaire rebinarisé dans une couche d'un réseau de neurones suivi d'une opération de modulation ;

la figure 6 est un schéma par bloc illustrant un exemple d'un circuit d'une couche complètement connectée intégrant un mécanisme de modulation sur un vecteur de sortie, selon un mode de réalisation de la présente description ;

la figure 7A illustre de façon schématique une séquence d'opérations permettant de réaliser un mécanisme de masquage binaire ;

la figure 7B illustre de façon schématique un autre exemple d'une séquence d'opérations de lecture-écriture d'un circuit mémoire permettant de réaliser un mécanisme de masquage; et

la figure 8 est un schéma par bloc illustrant un exemple d'un circuit d'une couche complètement connectée intégrant un mécanisme de modulation sur un vecteur issu d'un calcul intermédiaire et permettant de réaliser un mécanisme de masquage par une mise à jour conditionnelle du vecteur de sortie, selon un mode de réalisation de la présente description.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, le fonctionnement et l'implémentation des réseaux de neurones artificiels et en particulier des réseaux de neurones binaires, est connu par la personne du métier et n'est pas décrit en détail.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

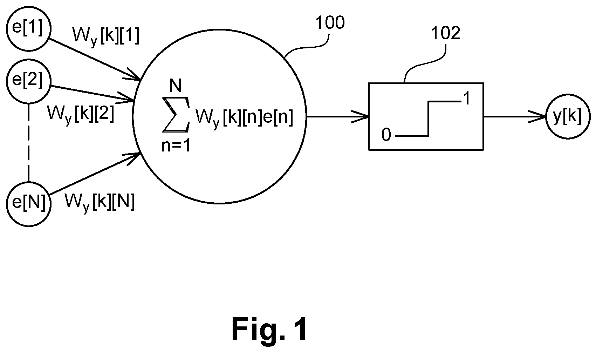

La figure 1 est un schéma par bloc illustrant un produit scalaire rebinarisé dans une couche d'un réseau de neurones.

A titre d'exemple, un vecteur $e = (e[1], e[2], \cdots, e[N])$, de taille $N$, $N$ étant un nombre entier supérieur ou égal à 1, est un vecteur d'entrée pour une couche du réseau de neurones. Chaque composante $e[n]$, $n \in \{1,...,N\}$, est une valeur binaire, égale à 0 ou à 1. Selon le type d'arithmétique binaire choisi, les valeurs binaires 0 et 1 quantifient respectivement soit des valeurs égales à 0 et 1, soit des valeurs égales à -1 et 1, soit deux autres valeurs par exemple égales à 0 et 2 ou - 2 et 2, etc.

A titre d'exemple, une opération de couche permet la génération d'un vecteur de sortie de couche y = $(y[1], y[2], \cdots, y[K])$, de taille $K$, où $N$ est un multiple de $K$. Chaque composante $y[k]$, $k \in \{1, \cdots, K\}$, du vecteur de sortie de couche est alors égale au produit scalaire 100 entre le vecteur d'entrée e et une ligne $W_y[k]$ d'une matrice de poids $W_y$ binarisée, par exemple par l'intermédiaire d'une fonction d'activation 102.

A titre d'exemple, le produit scalaire 100 est une composante $\hat{y}[k]$ définie comme étant la somme de la multiplication point à point du vecteur e avec le vecteur $W_y[k]$. Autrement dit $\hat{y}[k] = \sum_{n=1}^{N} W_y[k][n]e[n]$, où $W_y[k][n]$ est le coefficient sur la k-ème ligne, n-ième colonne de la matrice $W_y$. A titre d'exemple, chaque poids de la matrice de poids $W_y$ est une valeur binaire, dont la valeur 1 quantifie une valeur égale à 1, et la valeur 0 quantifie une valeur égale à 0 ou, par exemple à -1, etc., selon l'arithmétique utilisée.

La composante $y[k]$ est alors par exemple obtenue par application d'une fonction $b$ de binarisation à la valeur $\hat{y}[k]$, de sorte à transformer la valeur de $\hat{y}[k]$ en une valeur binaire. Autrement dit $y[k] = b(\hat{y}[k])$. A titre d'exemple, la fonction b est définie par :

[Math 1]

$$b(x) = \begin{cases} 1 \ si \ x > 0 \\ 0 \ si \ x \ \leq \ 0 \end{cases}.$$

Dans un autre exemple, une valeur de biais est ajoutée au produit scalaire 100, et dans ce cas, la valeur fournie à la fonction *b* est égale à $\hat{y}[k] = \sum_{n=1}^{N} W_y[k][n]e[n] + Biais[k]$, où *Biais[k]* est une valeur de biais pour la k-ème composante. A titre d'exemple, pour tout $k \in \{1, \cdots, K\}$, *Biais[k]* est une valeur constante, ne dépendant pas de la valeur de l'indice *k*.

A titre d'exemple, la fonction de binarisation *b* est mise en œuvre matériellement par un comparateur, ou par un convertisseur ADC-1b (de l'anglais « Single bit Analog to Digital Converter »).

Chaque composante *y[k]* du vecteur *y* de sortie de couche est donc une valeur binaire, appartenant à {0,1}. A titre d'exemple, selon l'arithmétique considérée, la valeur 0 quantifie une valeur égale à 0, ou une valeur égale, par exemple, à -1.

Selon un mode de réalisation, afin de prendre en compte la, ou les, arithmétiques considérées, le produit scalaire 100 est calculé à partir de fonctions de lectures. A titre d'exemple, les fonctions de lectures sont des fonctions prenant en entrée une valeur binaire, égale à 0 ou à 1, et configurées pour sortir une valeur appartenant, par exemple, à l'ensemble {0,1} ou à l'ensemble {-1,1}. Autrement dit, les fonctions de lecture permettent de transformer la valeur binaire encodant une valeur d'entrée, de poids, ou de sortie, en une valeur dans une autre représentation.

A titre d'exemple, les fonctions de lecture sont des fonctions parmi une fonction *g* de signe, définie par $g: u \to 2u - 1$, et une fonction *h* dite de type Heaviside et définie par $h: u \to u$. Ainsi, l'usage des fonctions de lecture permet d'avoir une arithmétique dans {-1,1} pour la fonction *g* et/ou dans {0,1} pour la fonction *h*. Dans la suite de la description, la fonction $f_y^{(W)}$ représentera la fonction de lecture appliquée à la matrice de poids de la couche courante pour le calcul de la sortie y, et la quantité $f_y^{(W)}(W_y)$ représente une matrice, de même taille que la matrice de poids $W_y$, et, pour tout $(n, k) \in \{1, \cdots, N\} \times \{1, \cdots, K\}$, $f_y^{(W)}(W_y)[k][n] = f_y^{(W)}(W_y[k][n])$. De même, la fonction $f_y^{(e)}$ représentera la fonction de lecture appliquée au vecteur d'entrée e de la couche courante pour le calcul de la sortie y, et la quantité $f_y^{(e)}(e)$ représente un vecteur, de même taille que le vecteur e, et, pour tout $n \in \{1, \cdots, N\}$, $f_y^{(e)}(e)[n] = f_y^{(1)}(e[n])$. Pour chaque couche, et donc pour chaque sortie de couche y, chacune des fonctions $f_y^{(W)}$ et $f^{(e)}$ est, dans cet exemple, soit égale à la fonction g soit à la fonction h. Ainsi, les fonctions de lectures $f_y^{(W)}$ et $f_y^{(e)}$ permettent que les produits scalaires sur chaque couche, aient lieu, par exemple, dans les ensembles $\{0,1\}^N \times \{0,1\}^N$, $\{0,1\}^N \times \{-1,1\}^N$, $\{-1,1\}^N \times \{0,1\}^N$ et/ou $\{-1,1\}^N \times \{-1,1\}^N$. Ces ensembles sont donnés à titre d'exemple, d'autres arithmétiques sont bien sûr envisageables, et dans ce cas les fonctions de lectures devront être adaptées par la personne du métier afin d'être à valeurs dans les ensembles voulus. Dans la suite de la description, pour tout vecteur u apparaissant dans une opération de couche, des fonctions de lecture $f_u^{(W)}$ et $f_u^{(e)}$ sont des fonctions de lecture parmi les fonctions g et h utilisées dans le calcul du vecteur u. Le produit scalaire entre les deux vecteurs $f_y^{(e)}(e)$ et $f_y^{(W)}(W_y[k])$ est alors noté $f_y^{(e)}(e)f_y^{(W)}(W_y[k])$.

Selon un mode de réalisation, considérant que chacune des composantes du vecteur d'entrée e, ainsi que chacun des coefficients de la matrice de poids $W_y$, sont des valeurs binaires, dans {0,1}, le vecteur y de sortie de couche est tel que $y = b\left(f_y^{(W)}(W_y)f_y^{(e)}(e)\right)$, où $f_y^{(W)}(W_y)f_y^{(e)}(e)$ est un vecteur de taille *K*, dont chaque composante est égale au produit scalaire entre le vecteur e et une ligne de la matrice de poids $W_y$. Le vecteur de sortie est donc lui aussi à valeurs binaire dans $\{0,1\}^K$.

A titre d'exemple, le vecteur y de sortie de couche pour une couche courante est un vecteur d'entrée pour une couche suivante. A titre d'exemple, pour cette couche suivante, l'arithmétique représentant le vecteur d'entrée y est différente de celle représentant le vecteur d'entrée e pour une couche courante. De même, dans un exemple, la matrice de poids pour cette couche suivante a une représentation différente de celle de la matrice $W_y$ de la couche courante. Dans un autre exemple, les représentations du vecteur y, et/ou de la matrice de poids pour cette couche suivante, sont les mêmes que les représentations de vecteur e et/ou de la matrice $W_y$ pour la couche courante. Les fonctions de lecture utilisées d'une couche à l'autre peuvent donc varier.

Selon un mode de réalisation, une ou plusieurs couches du réseau de neurones sont configurées pour appliquer en outre une opération de masquage (en anglais « gating », ou « attention-like »). L'opération de masquage masque par exemple certaines composantes du vecteur de sortie de couche y. Un vecteur masqué est alors fourni en donnée d'entrée à la couche suivante du réseau. Les opérations de masquage permettent de sélectionner et/ou de moduler les sorties en fonction d'un contexte, ou d'une classification antérieure.

Selon un mode de réalisation, un vecteur de sortie s, obtenu par masquage du vecteur de sortie y, est défini par :

[Math 1]

$$s = \bar{z} \cdot x + z \cdot y,$$

où l'opérateur " · " représente un produit de Hadamard, ou produit point par point, et où le vecteur x à valeurs dans $\{0,1\}^K$ est issu du vecteur d'entrée e, et/ou d'états internes et/ou intermédiaires calculés précédemment dans la couche courante, ou dans une couche précédente. En particulier, l'opérateur " · " représente une opération de modulation. Le vecteur z est un vecteur binaire, à valeurs dans $\{0,1\}^K$, et est un vecteur de masquage. Le vecteur $\bar{z}$ correspond au vecteur qui, quand on le somme avec le vecteur z, résulte en un vecteur composé uniquement de 1. Ainsi, le vecteur s comprend certaines de ses composantes issues du vecteur x et les autres de ses composantes issues du vecteur de sortie y. L'opération de masquage susmentionnée est une opération de masquage de type « multiplexage ». D'autres opérations dîtes de masquage peuvent être réalisées en appliquant une autre fonction, par exemple en faisant une opération de modulation entre 2 vecteurs avec un vecteur présentant des propriétés « tout ou rien », par exemple avec des valeurs à « 0 ».

Selon un mode de réalisation, s est tel que $s = \bar{z} \cdot x + z \cdot y$, où, par exemple, $z = b\left(f_z^{(W)}(W_z) f_z^{(e)}(e)\right)$, $W_z$ étant une matrice de poids, $x = b\left(f_x^{(W)}(W_x) f_x^{(e)}(e)\right)$, $W_x$ étant une autre matrice de poids, et où y est le vecteur de sortie décrit précédemment, ou $y = e$. Les fonctions $f_z^{(W)}$, $f_z^{(e)}$, $f_x^{(W)}$ et $f_x^{(e)}$ sont des fonctions de lectures, respectivement associées aux vecteurs z et x et, par exemple égales à la fonction g et/ou à la fonction h. Ainsi définis, les vecteurs z, x et y sont issus de projections du vecteur e, ou directement égaux, au vecteur e. Le masquage ainsi réalisé permet d'adapter et de prendre en compte des valeurs obtenues par projection du passé, le passé étant défini par le vecteur d'entrée de couche.

A titre d'exemple, les opérations de masquage sont généralement réalisées dans des réseaux de neurones dits récurrents (RNN - « Recurrent Neural Network ») où une rétroaction est appliquée dans le calcul du vecteur de sortie s. En effet, dans le cas du traitement d'un vecteur de données, à chaque indice t de ce vecteur, les équations impliquées dans les réseaux de neurones récurrents utilisent généralement des versions antérieures aux vecteurs calculés à l'instant t, c'est à dire par exemple des vecteurs $s_{t-1}$ et $h_{c-1}$ ayant été calculés à un instant t- 1. Ce type d'opération permet notamment une mémorisation des états passés. Les structures récurrentes sont, par exemple, analogues à un filtrage de type à réponse impulsionnelle infinie.

Selon un mode de réalisation, un vecteur $d_t$ dans $\{0,1\}^{2N}$ est défini comme étant la concaténation d'un vecteur d'entrée $e_t$ dans $\{0,1\}^N$ d'une couche d'un RNN et d'un vecteur $h_{t-1}$ dans $\{0,1\}^N$, soit $d_t = concat(e_t, h_{t-1})$ et un vecteur $d'_t$ dans $\{0,1\}^{2N}$ est défini comme étant la concaténation du vecteur d'entrée $e_t$ dans $\{0,1\}^N$ et d'un vecteur de sortie $s_{t-1}$ dans $\{0,1\}^N$ d'une couche du RNN, soit $d'_t = concat(e_t, s_{t-1})$. Plusieurs variantes de structures récurrentes sont définissables, à partir de fonctions de lecture telles que décrites précédemment.

A titre d'exemple, le tableau suivant présente des différents vecteurs intervenant dans des opérations de couches d'un réseau de type mémoire à long court terme (LSTM-de l'anglais « Long Short-Term Memory »). En particulier, chaque vecteur parmi des vecteurs (*z,r,o,y,x,s,h*) est à valeur binaire dans $\{0,1\}^N$ et est associé à des fonctions de lecture permettant sa description dans une autre arithmétique. Pour ce faire, chaque matrice du tableau suivant est à valeur binaire dans $\{0,1\}^N \times \{0,1\}^{2N}$ et est associé à des fonctions de lecture permettant sa description dans une autre arithmétique.

[Table 1]

$$z_t = b\left(f_z^{(W)}(W_z)\, f_z^{(e)}(d_t)\right)$$

$$r_t = b\left(f_r^{(W)}(W_z)\, f_r^{(e)}(d_t)\right)$$

$$o_t = b\left(f_o^{(W)}(W_o) f_o^{(e)}(d_t)\right)$$

$$y_t = b\left(f_y^{(W)}(W_y) f_y^{(e)}(d_t)\right)$$

$$x_t = b\left(f_x(y_t) \cdot f_x(r_t)\right)$$

$$s_t = \bar{z}_t \cdot x_t + z_t \cdot s_{t-1}$$

$$h_t = b\left(f_h(s_t) \cdot f_h(o_t)\right)$$

Le tableau suivant présente des différents vecteurs intervenant dans des opérations de couches d'un réseau de type LSTM.

[Table 2]

$$z_t = b\left(f_z^{(W)}(W_z)\, f_z^{(e)}(d_t)\right)$$

$$r_t = b\left(f_r^{(W)}(W_r)\, f_r^{(e)}(d_t)\right)$$

$$o_t = b\left(f_o^{(W)}(W_o) f_o^{(e)}(d_t)\right)$$

$u_t = concat(\{1,1, \cdots,1\}; r_t)$

$y_t = b\,(f_y(d_t) \cdot f_y(u_t))$

$$x_t = b\left(f_x^{(W)}(W_x) f_x^{(e)}(y_t)\right)$$

$s_t = \bar{z}_t \cdot x_t + z_t \cdot s_{t-1}$

$h_t = b(f_h(s_t) \cdot f_h(o_t))$

Dans cet exemple, chaque fonction de lecture pouvant être choisie parmi les fonctions g et *h*, $2^{10}$ implémentations sont possibles.

Le tableau suivant présente des différents vecteurs intervenant dans des opérations de couches d'un réseau de type unité récurrent sélective (GRU-de l'anglais « Gated Recurrent Unit ») dans une variante canonique.

[Table 3]

$$z_t = b\left(f_z^{(W)}(W_z)\, f_z^{(e)}(d'_t)\right)$$

(suite)

$$r_t = b\left(f_r^{(W)}(W_{zr})\, f_r^{(e)}(d'_t)\right)$$

| |
|---|
| $u_t = concat(\{1,1,\cdots,1\}; r_t)$ |
| $y_t = b\,(f_y(d'_t)\cdot f_y(u_t))$ |
| $x_t = b\left(f_x^{(W)}(W_x) f_x^{(e)}(y_t)\right)$ |
| $s_t = \overline{z}_t \cdot x_t + z_t \cdot s_{t-1}$ |

Dans cet exemple, chaque fonction de lecture pouvant être choisie parmi les fonctions g et *h*, $2^7$ implémentations sont possibles.

Le tableau suivant présente des différents vecteurs intervenant dans des opérations de couches d'un réseau de type unité minimale sélective (MGU-de l'anglais « Minimal Gated Unit ») dans une variante canonique.

[Table 4]

$$z_t = b\left(f_z^{(W)}(W_z)\, f_z^{(e)}(d'_t)\right)$$

| |
|---|
| $u_t = concat(\{1,1,\cdots,1\}; z_t)$ |
| $y_t = b\,(f_y(d'_t) \cdot f_y(u_t))$ |
| $x_t = b\left(f_x^{(W)}(W_x) f_x^{(e)}(y_t)\right)$ |
| $s_t = \overline{z}_t \cdot x_t + z_t \cdot s_{t-1}$ |

Dans cet exemple, chaque fonction de lecture pouvant être choisie parmi les fonctions g et h, $2^5$ implémentations sont possibles.

Chacune des tableaux Table 1 à Table 4 ci-dessus présente alors des exemples d'algorithmes dans lesquels les vecteurs $s_t$ et/ou $h_t$ sont obtenus suite aux calculs de plusieurs produits scalaire entre des vecteurs intermédiaires. Les calculs des vecteurs $s_t$ et/ou $h_t$ sont par exemple réalisés en plusieurs étapes. Des premières étapes comprennent la génération, par exemple de façon séquentielle, d'un ou plusieurs vecteurs intermédiaires. Dans certains exemples, des vecteurs intermédiaires, tel que le vecteur $y_t$, sont obtenus par modulation, noté par l'opérateur « · » dans les tableaux Table 2 à Table 4. Dans certains exemples, des vecteurs tel que le vecteur $s_t$ sont obtenus par opération de masquage dans les tableaux Table 1 à Table 4.

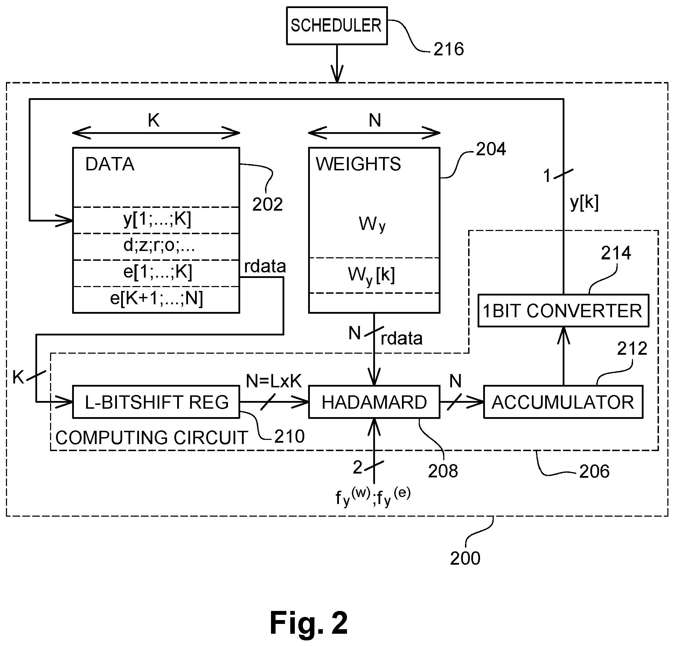

La figure 2 est un schéma par bloc illustrant un exemple d'architecture proche mémoire d'un réseau complètement connecté, selon un mode de réalisation de la présente description. En particulier, la figure 2 représente un circuit 200 comprenant deux éléments de mémoire 202 (DATA) et 204 (WEIGHTS).

A titre d'exemple, les éléments mémoire 202 et 204 sont deux mémoires distinctes du circuit 200. A titre d'exemple, l'élément mémoire 202 est configuré pour stocker des données de longueur K, ou autrement dit pour stocker un mot présentant K bits. En particulier, l'élément de mémoire 202 est configuré pour stocker des données calculées lors des opérations de couches, telles que par exemple, le vecteur d'entrée e, les vecteurs *x, y, s, h, u, r, z*, o et tout autre vecteur de longueur K, ou d'un multiple de K, intervenant dans une opération de couche. La longueur de ces vecteurs stockés dans l'élément mémoire 202 est de préférence un multiple de K, tel que N=L*K avec L un nombre entier positif. De façon avantageuse, on choisira une longueur K correspondant à la taille d'un vecteur de plus petite taille parmi les vecteurs manipulés au cours des opérations, comme cela sera expliqué plus en détails infra.

A titre d'exemple, lors de l'exécution du réseau de neurones, les données stockées dans l'élément mémoire 202 sont dynamiquement supprimés et écrits. A titre d'exemple, un vecteur d'entrée de couche e est supprimé suite au calcul d'un vecteur y de sortie de cette même couche et le vecteur y est stocké dans la mémoire 202 comme vecteur d'entrée pour la couche suivante. De même, chaque vecteur *x, y, s, h, u, r, z*, o calculé lors d'une opération pour une couche du réseau est par exemple remplacé par sa nouvelle version pour la couche suivante.

A titre d'exemple, des opérations de modulation et/ou de masquage sont effectuées en direct et de manière dynamique, c'est à dire sans stockage préalable de l'un et/ou l'autre des vecteurs intermédiaires intervenant dans l'opération.

A titre d'exemple, l'élément mémoire 204 est de largeur N. L'élément mémoire 204 est par exemple configuré pour stocker une ou plusieurs matrices de poids, telles que les matrices $W_y$, $W_z$, $W_r$, $W_o$, $W_x$, etc. pour chaque étage de calcul et pour chaque couche du réseau de neurones. Les matrices stockées dans l'élément mémoire 204 ont des lignes présentant une longueur de préférence égale à N, ou 2N selon les exemples, afin de pouvoir obtenir directement l'intégralité d'une ligne de la matrice de poids stockée dans la mémoire 204. Dans d'autres cas, il sera également possible de prendre une matrice présentant une taille de lignes présentant un sous-multiple de N et dans ce cas, il faudra, comme pour les données, prévoir un registre accumulateur et une lecture séquentielle des différentes parties d'une ligne de la matrice pour reconstituer un mot correspondant à l'ensemble des bits d'une ligne de matrice.

Le circuit 200 comprend en outre un circuit de calcul 206 (COMPUTING CIRCUIT) configuré, par exemple, pour générer les composantes y[k] vecteur de sortie y de couche, à partir des données comprises dans la mémoire 202 et d'une ou plusieurs matrices comprises dans la mémoire 204. Le vecteur de sortie de couche est alors un vecteur binaire à valeur dans $\{0,1\}^K$.

A titre d'exemple, le circuit de calcul 206 comprend un circuit 208 (HADAMARD) configuré pour effectuer une opération telle qu'un produit d'Hadamard, à partir d'un vecteur compris dans la mémoire 202 et une matrice, ou une ligne ou colonne d'une matrice, comprise dans la mémoire 204.

Selon un mode de réalisation, le circuit est en outre configuré pour recevoir, par exemple par l'intermédiaire d'une signal 2 bits et lors de l'exécution de chaque couche, une information indiquant quelles sont les fonctions de lecture à appliquer aux données et aux poids avant de leur appliquer l'opération de produit scalaire. A titre d'exemple, pour une même couche, les opérations de couches intermédiaires, aboutissant au vecteur de sortie y, font appel à différentes fonctions de lecture, par exemple les fonctions $f_o^{(e)}, f_o^{(W)}, f_z^{(e)}, f_z^{(W)}$ etc. Les fonctions de lecture utilisées lors des opérations ont la possibilité de différer les unes des autres. A titre d'exemple, les fonctions $f_o^{(e)}$, $f_z^{(e)}$ et $f_y^{(e)}$ ne sont pas toutes identiques.

Selon un mode de réalisation, dans le cas où le nombre entier N est strictement supérieur à l'entier K et est un multiple entier de la valeur K, le circuit de calcul 206 comprend en outre un ou plusieurs registres à décalage 210 (L-BITSHIFT REG). En particulier, en considérant l'entier L, tel que $N = L \times K$, le circuit de calcul 206 comprend un nombre L de registres à décalage, chaque registre à décalage étant configurée pour décaler les données reçues de K bits. Les L registres à décalage permettent de réorganiser des données, non contiguës dans la mémoire 202, afin de fournir au circuit 208 des données de dimension N appropriée à l'opération effectuée avec la, ou les, matrices de poids. Les L registres à décalage permettent en outre de manipuler des tenseurs dans le cas de couches de convolution en deux dimensions (2D). Le, ou les, registres 210 permettent en outre de réaliser des concaténations, par exemple permettant de générer les vecteurs e de longueur N issus de la concaténation de plusieurs lignes de la mémoire 202, chaque ligne comprenant les données de K canaux d'un tenseur de données à une position spatiale, ou pixel, d'une image I de dimension $H \times W \times K$, où H et W représentent respectivement les dimensions spatiales, soit verticale pour la valeur H et horizontale pour la valeur W. L'adaptation de schémas de lecture de la mémoire 202 vers des convolutions de dimension différente de deux est à la portée de la personne du métier.

Le circuit 208 comprend, par exemple, un nombre N de portes XNOR, configurées pour réaliser l'opération lorsque les arithmétiques du vecteur et de la matrice de poids sont, toutes les deux, dans $\{-1,1\}$. Autrement dit, les N portes XNOR sont configurées pour réaliser l'opération lorsque l'indication reçue par le circuit 208 indique que les fonctions de lectures sont toutes les deux la fonction g. Le circuit 208 comprend, par exemple, en outre une ou plusieurs portes AND configurées pour masquer des entrées lorsqu'une des deux arithmétiques est dans $\{0,1\}$. Autrement dit, l'une ou plusieurs portes AND permettent de réaliser, en combinaison avec les N portes XNOR, les opérations lorsqu'au moins une des fonctions de lecture est la fonction de Heaviside h.

Le circuit de calcul 206 comprend en outre un accumulateur 212 (ACCUMULATOR), relié au circuit 208 et configuré pour additionner les résultats de multiplications points par point réalisées par le circuit 208. Selon un mode de réalisation, l'accumulateur 212 est un arbre additionneur signé (en anglais « signed adder tree »).

Le circuit de calcul 206 comprend en outre un convertisseur 214 (1BIT CONVERTER) configuré pour binariser la valeur générée par l'accumulateur 212. Dans la suite de la description, le terme « binarisation » renvoie à une opération de quantification d'un signal sur deux niveaux que l'on représente par les valeurs « 0 » et « 1 ». A titre d'exemple, le convertisseur 214 est un comparateur, configuré pour recevoir en entrée des valeurs numériques. Dans un autre exemple, le convertisseur 214 est un circuit ADC (de l'anglais « Analog to Digital Converter ») configuré pour recevoir en entrée des valeurs analogiques. A titre d'exemple, le convertisseur 214 est configuré pour appliquer la fonction de binarisation b à la valeur générée par l'accumulateur 212. Le convertisseur 214 est, par exemple, en outre configuré pour écrire la valeur binarisée dans la mémoire 202.

Selon un mode de réalisation, le circuit de calcul 206 est alors configuré pour pouvoir effectuer des opérations, telles que des produits scalaires, à partir de valeurs binaires tout en respectant une configuration dans une arithmétique donnée. L'arithmétique n'est alors pas fixée et est indiquée au circuit 206 lors de l'exécution de chaque opération de couche. En particulier, l'arithmétique peut varier entre chaque opération de couche. A titre d'exemple, un premier produit scalaire est alors réalisé dans l'ensemble $\{-1,1\}^N \times \{0,1\}^N$ et un deuxième produit scalaire est alors réalisé dans l'ensemble $\{0,1\}^N \times \{0,1\}^N$, etc. Dans un cas d'un usage nominal, chaque couche peut utiliser sa propre arithmétique et sera paramétrée par seulement $f_y^{(e)}$ et $f_y^{(w)}$.

Selon un mode de réalisation, le circuit 200 comprend, ou est relié à, un circuit ordonnanceur 216 (SCHEDULER) configuré pour commander l'exécution d'opérations de couches telles que par exemple décrites en relation avec l'une parmi les tableaux Table 1 à Table 4. Le circuit ordonnanceur 216 est en outre configuré pour piloter les accès mémoire en lecture et en écriture. En particulier, le circuit ordonnanceur 216 est configuré pour commander l'écriture, par exemple séquentiellement, de chacun des vecteurs intermédiaires, et des vecteur x et/ou y dans la mémoire 202. A titre d'exemple, le circuit ordonnanceur 216 est un coprocesseur dans un système englobant le circuit 200 et le circuit ordonnanceur 216. Le circuit ordonnanceur 216 permet en outre de séquencer les différentes opérations de couches réalisées par les différents éléments du circuit 200.

En opération, le circuit ordonnanceur 216 est par exemple configuré pour commander le circuit de calcul 206 pour faire plusieurs tours de calcul et générer ainsi les vecteurs correspondants au traitement à réaliser, tel que l'un ou plusieurs des traitements exposés dans les tableaux Table 1 à Table 4 ci-dessous. Les vecteurs générés à chaque tour sont par exemple stockés dans la mémoire 202, et à la fin du traitement, le vecteur y de sortie est par exemple disponible dans cette mémoire 202.

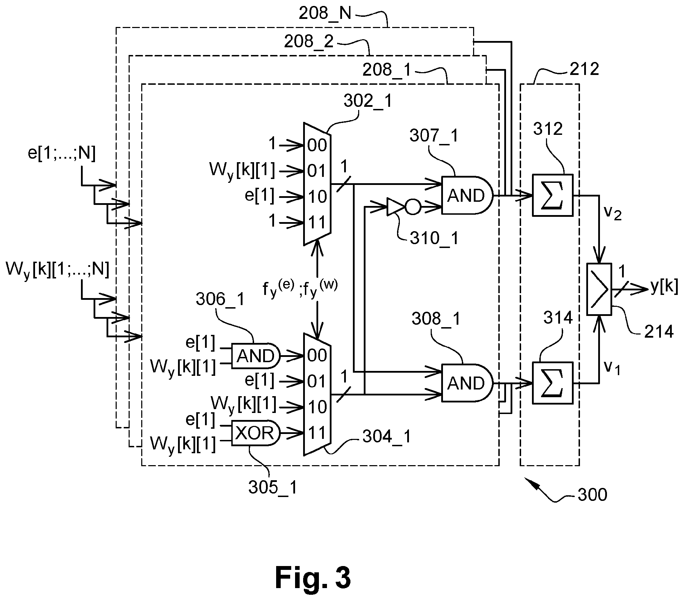

La figure 3 est un schéma illustrant un exemple d'un circuit 300 implémentant un opérateur de produit scalaire requantifié. En particulier, le circuit 300 illustre un exemple de réalisation du circuit 208, de l'accumulateur 212 et du convertisseur 214 de la figure 2 sous la forme d'un calcul réalisé sur deux voies. Ces deux voies sont séparées, par exemple de façon à pouvoir effectuer des calculs quelles que soient les arithmétiques utilisées, c'est à dire, quelles que soient les fonctions de lecture $f_y^{(e)}$ et $f_y^{(w)}$ utilisées. Par exemple, le circuit 208 comprend un nombre N de sous-circuit 208_1 à 208_N.

Dans l'exemple illustré en figure 3, le circuit 300 est configuré pour générer une composante y[k], du vecteur de sortie y, sur la base d'un vecteur d'entrée e stocké dans la mémoire 202 et de la k-ième ligne d'une matrice de poids $W_y$, stockée dans la mémoire 204 et de l'indication de deux fonctions de lecture $f_y^{(e)}$ et $f_y^{(W)}$. En particulier, le circuit 300 est configuré pour réaliser l'opération y[k] = $b\left(f_y^{(W)}\left(W_y[k]\right)f_y^{(e)}(e)\right)$, pour tout $k \in \{1,\cdots,K\}$.

Chaque circuit 208_i, $i \in \{1,\cdots,N\}$, est configuré pour recevoir la i-ème composante e[i] du vecteur d'entrée e et l'élément $W\_y[k][i]$. Ces valeurs sont par exemple fournies à des multiplexeurs 302_i et 304_i. A titre d'exemple, les multiplexeurs 302_i et 304_i sont configurés pour sélectionner une configuration, parmi des configurations 00, 01, 10 et 11, sur la base de l'indication des fonctions de lecture $f_y^{(e)}$ et $f_y^{(W)}$. A titre d'exemple, la configuration 00 représente la configuration dans laquelle $f_y^{(e)} = h$ et $f_y^{(W)} = h$, la configuration 01 représente la configuration dans laquelle $f_y^{(e)} = h$ et $f_y^{(W)} = g$, la configuration 10 représente la configuration dans laquelle $f_y^{(e)} = g$ et $f_y^{(W)} = h$, et la configuration 11 représente la configuration dans laquelle $f_y^{(e)} = g$ et $f_y^{(W)} = g$. Les valeurs e[i] et $W_y[k][i]$ sont en outre fournies à une porte XOR 305_i configuré pour effectuer l'opération e[i] XOR $W_y[k][i]$ ainsi qu'à une porte AND 306_i configurée pour effectuer l'opération e[i] AND $W_y[k][i]$.

A titre d'exemple, dans la configuration 00, le multiplexeur 302_i est configuré pour sélectionner une valeur égale à 1 et le multiplexeur 304_i est configuré pour sélectionner la sortie de la porte AND 306_i. Dans la configuration 01, le multiplexeur 302_i est, par exemple, configuré pour sélectionner la valeur $W_y[k][i]$ et le multiplexeur 304_i est, par exemple, configuré pour sélectionner la composante e[i]. Dans la configuration 10, le multiplexeur 302_i est, par exemple, configuré pour sélectionner la composante e[i] et le multiplexeur 304_i est, par exemple, configuré pour sélectionner l'élément $W_y[k][i]$. Dans la configuration 11, le multiplexeur 302_i est, par exemple, configuré pour sélectionner une valeur égale à 1 et le multiplexeur 304_i est, par exemple, configuré pour sélectionner la sortie de la porte XOR 305_i.

A titre d'exemple, le multiplexeur 302_i est configuré pour transmettre la valeur sélectionnée vers une entrée d'une porte AND 307_i et vers une entrée d'une porte AND 308_i. Le multiplexeur 304_i est, par exemple, configuré pour transmettre la valeur sélectionnée vers l'autre entrée de la porte 308_i et vers l'entrée d'un inverseur 310_i. L'inverseur 310_i est alors configuré pour inverser la valeur, c'est à dire à générer la valeur 0 lorsque la valeur fournie est égale à 1 et inversement, et pour la fournir à l'autre entrée de la porte 307_i.

La porte 307_i est alors configurée pour appliquer l'opération AND sur les valeurs transmises par le multiplexeur 302_i et l'inverseur 310_i. La porte 308_i est alors configurée pour appliquer l'opération AND sur les valeurs transmises par les multiplexeurs 302_i et 304_i.

Chacune des portes 307_i et 308_i de chacun des sous circuits 208_1 à 208_N est configurée pour fournir la valeur générée à l'accumulateur 212. En particulier, les portes 307_1 à 307_N sont configurées pour fournir les valeurs générées à un circuit additionneur 312 et les portes 308_1 à 308_N sont configurées pour fournir les valeurs générées à un circuit additionneur 314. Les additionneurs 312 et 314 sont respectivement configurés pour générer une valeur $v_2$, $v_1$, correspondant, par exemple, à la somme des valeurs fournies par les portes 307_1 à 307_N et 308_1 à 308_N.

Les additionneurs 312 et 314 sont alors configurés pour fournir les valeurs $v_1$ et $v_2$ au comparateur 214. A titre d'exemple, le comparateur 214 est configuré pour générer la valeur binaire 1 dans le cas où la valeur $v_1$ est supérieure à la valeur $v_2$ et pour générer la valeur binaire 0 dans le cas contraire. La valeur binaire générée correspond au produit scalaire

$$y[k] = b\left(f_y^{(W)}(W_y[k])f_y^{(e)}(e)\right)$$

.

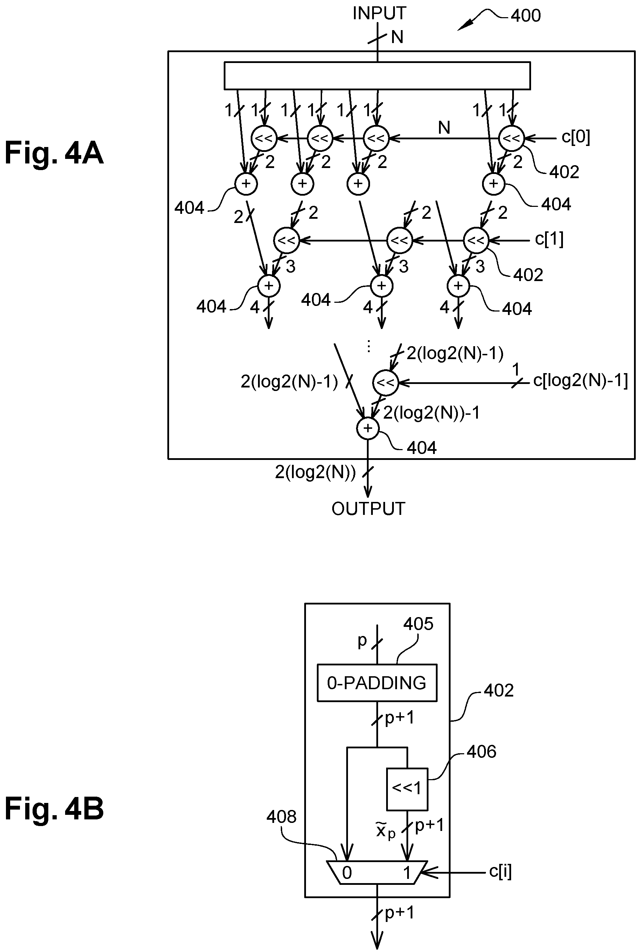

La figure 4A est un schéma illustrant un exemple d'arbre additionneur 400, selon un mode de réalisation de la présente description. En particulier, l'arbre additionneur 400 est un exemple d'implémentation des circuits additionneurs 312 et 314. Selon un mode de réalisation, l'arbre additionneur 400 comprend un nombre $log_2(N)$ d'étages, chaque étage comprenant un ou plusieurs circuits de décalage programmables de bits 402 et un même nombre d'additionneur 404.

A titre d'exemple, l'arbre additionneur 400 est configuré pour recevoir un mot (INPUT) de N bits et pour générer une valeur de sortie (OUTPUT), sur la base d'un vecteur $c = (c[0], c[1], \cdots, c[log_2(N) - 1])$ de longueur $log_2(N)$. Le mot reçu par le circuit 400 correspond aux N bits transmis par les circuits 208_1 à 208_N. A titre d'exemple, sur un premier étage, l'arbre additionneur 400 comprend un nombre $N/2$ de circuits de décalage programmables de bits 402. A titre d'exemple, l'additionneur 400 est configuré pour fournir chaque bit de rang impair, ou de rang pair, vers un circuit de décalage 402. Autrement dit, un bit sur deux du mot d'entrée est fourni à un circuit de décalage 402. Sur ce premier étage, chaque circuit de décalage 402 reçoit donc un bit en entrée.

La figure 4B est un schéma illustrant un exemple d'un circuit de décalage de bits programmable 402, selon un mode de réalisation de la présente description.

Chaque circuit de décalage 402 est configuré pour recevoir un mot comprenant des bits $x_p$, par exemple un nombre $p$ de bits, $p$ étant un nombre entier supérieur ou égal à 1. Le circuit 402 comprend un circuit 405 (0-PADDING) configuré pour ajouter un bit au mot $x_p$. A titre d'exemple, le circuit 405 est configuré pour générer un mot de p+1 bits dont le bit le plus significatif est programmé à la valeur 0 et dont les p bits les moins significatifs correspondent au mot $x_p$. A titre d'exemple, le circuit 405 est configuré pour appliquer la méthode dite « 0 Maximum Padding » sur le mot reçu.

Chaque circuit de décalage 402 comprend par exemple un registre à décalage 406, configuré pour générer un mot $\tilde{x}_p$, correspondant à la multiplication par deux d'un nombre entier non signé représenté en binaire dit « gros boutiste » (Big-Endian Unsigned Integer, en anglais) par le mot $x_p$, en décalant d'un bit le mot d'entrée $x_p$ et en mettant un « 0 » sur le bit le moins significatif. Chaque circuit de décalage 402 comprend, par exemple, en outre un multiplexeur 408. Le multiplexeur 408 est, par exemple, configuré pour sélectionner un mot, parmi le mot $x_p$ et le mot $\tilde{x}_p$, sur la base d'une valeur d'un bit $c[i]$ du mot $c$ à l'indice $i$. A titre d'exemple, si le bit $c[i]$ à pour valeur 0, le multiplexeur 408 est configuré pour sélectionner le mot $x_p$ et si le bit $c[i]$ à pour valeur 1, le multiplexeur 408 est configuré pour sélectionner le mot $\tilde{x}_p$.

A titre d'exemple, les circuits de décalage 402 du premier étage de l'arbre 400 de la figure 4A sont donc configurés pour générer des mots de 2 bits. Chaque circuit de décalage 402 est en outre configuré pour fournir le mot généré à un additionneur404. A titre d'exemple, chaque additionneur 404 du premier étage de l'arbre 400 est en outre configuré pour recevoir un bit du mot d'entrée n'ayant pas été fourni à un circuit de décalage 402. A titre d'exemple, pour chaque bit de rang n dans le mot d'entrée fourni à un circuit de décalage 402, le bit de rang $n$ - 1 est fourni à l'additionneur 404 recevant le mot généré par ledit circuit de décalage, à partir du bit de rang n. Chaque additionneur 404 est configuré pour générer un mot en additionnant les deux valeurs reçues. A titre d'exemple, le mot généré par un additionneur 404 du premier étage de l'arbre 400 est de longueur 2. En effet, la valeur maximale atteignable, sur le premier étage, en représentation entière, est 2+1=3 et peut être représentée en binaire par le mot 11, codable donc sur 2 bits. A partir de l'étage suivant, chaque additionneur 404 est configuré pour générer un mot comprenant un bit supplémentaire à celui fourni par le circuit de décalage 402. En effet, sur chacun de ces étages, la valeur maximale atteignable dépasse la dynamique associée au nombre de bits du mot fourni par le circuit de décalage 402.

A titre d'exemple, suite au traitement du mot d'entrée par le premier étage de l'arbre 400, N/2 mots de 2 bits sont fournis à un deuxième étage de l'arbre 400.

Le fonctionnement du deuxième étage de l'arbre 400 est, par exemple, identique à celui du premier étage. Chaque additionneur 404 du deuxième étage est alors configuré pour transmettre le mot généré à, selon sa position dans l'arbre 400, un circuit de décalage 402 du deuxième étage ou un additionneur 404 du deuxième étage.

Le dernier étage de l'arbre 400, c'est à dire le $log_2(N)$-ème étage, comprend alors un unique circuit de décalage 402 et un unique additionneur 404. Ce dernier additionneur 404 est configuré pour générer un mot de sortie (OUTPUT) de l'arbre 400, comprenant par exemple $2log_2(N)$ bits. Comme pour les étages précédents, l'additionneur 404 du dernier étage est configuré pour générer le mot de sortie en additionnant le mot généré par le circuit de décalage 402 du dernier étage avec une valeur fournie par un des deux additionneurs 404 sur l'avant-dernier étage. En particulier, l'avant dernier étage comprenant deux additionneurs 404, l'un est configuré pour fournir le mot qu'il génère au circuit de décalage 402 du dernier étage et l'autre est configuré pour fournir le mot qu'il génère à l'additionneur 404 du dernier étage. Le circuit de décalage 402 du dernier étage est alors configuré pour effectuer une sélection sur la base de la valeur du bit $c[log_2(N)$ **-1].**

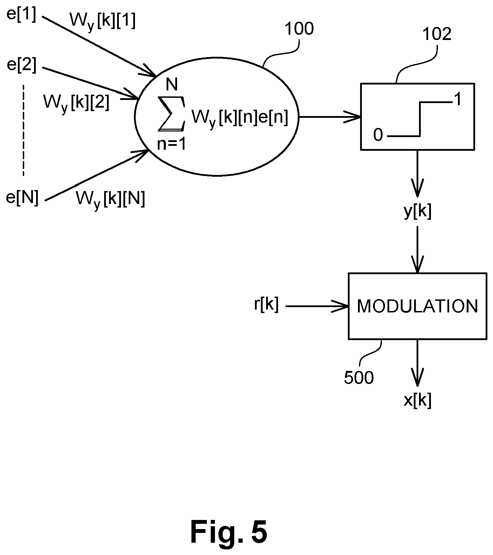

La figure 5 est un schéma par bloc reprenant le produit scalaire rebinarisé, décrit en relation avec la figure 1, suivi d'une opération de modulation.

Selon un mode de réalisation, la sortie y[k] binarisée est fournie à un bloc de modulation 500 (MODULATION). A titre d'exemple, le bloc de modulation 500 est configuré pour recevoir un vecteur, tel que par exemple la donnée intermédiaire r. Le bloc de modulation 500 est alors configuré pour effectuer une opération de modulation entre chaque coefficient de sortie $y[k]$ et chaque coefficient $r[k]$ du vecteur r. A titre d'exemple, le bloc 500 génère le coefficient $x[k]$, correspondant par exemple à y[k] lorsque la valeur de $r[k]$ est égal à 1, ou correspondant à la valeur 0 lorsque $r[k]$ est égal à 0. Le vecteur x correspond alors au produit point par point entre les vecteurs y et r.

Dans l'exemple décrit en relation avec le tableau Table 1, le bloc 500 est configuré pour générer chaque coefficient du vecteur x en appliquant l'opération de modulation entre $f_x(y[k])$ et $f_x(r[k])$. Le vecteur x généré est alors égal à $f_x(y) \cdot f_x(r)$.

A titre d'exemple, chaque coefficient du vecteur y est fourni au bloc 500 directement et sans être préalablement stocké dans une mémoire.

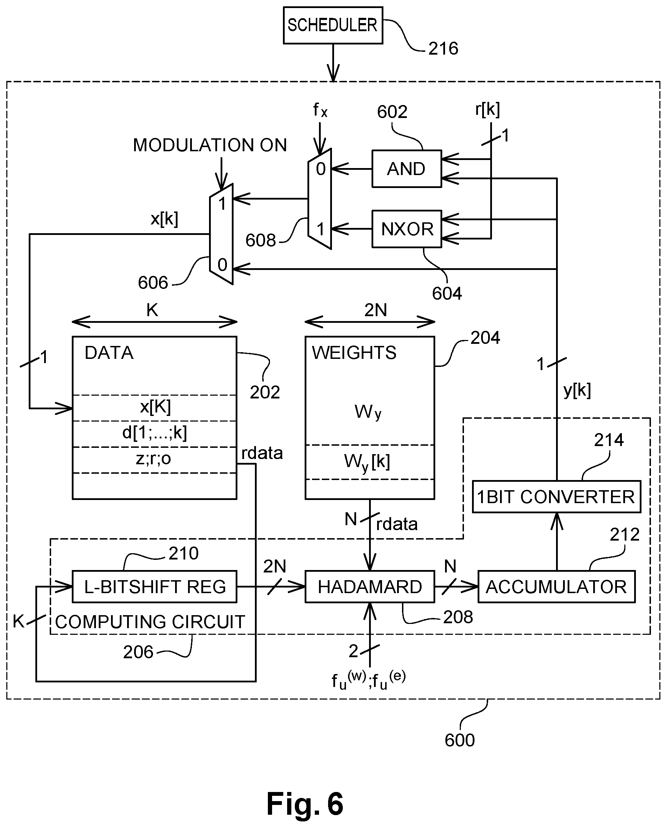

Un exemple d'implémentation du bloc 500 est décrit en détail en relation avec la figure 6.

La figure 6 est un schéma par bloc illustrant un circuit 600 configuré pour effectuer des opérations de couches comprenant, entre autres, des opérations de modulation, selon un mode de réalisation de la présente description. A titre d'exemple, le circuit 600 illustre des exemples de réalisation du circuit 200 et comprend les éléments 202 à 214 décrits en relation avec la figure 2. Le circuit 600 comprend en outre le, ou est relié au, circuit ordonnanceur 216 configuré pour commander et piloter l'exécution des opérations de couches en relation avec, par exemple, une parmi les tables 1 à 4.

A titre d'exemple, le circuit de calcul 206 du circuit 600 est, en outre, configuré pour calculer les composantes d'un ou plusieurs vecteurs « intermédiaires » correspondants, par exemple, aux vecteurs y, z, r et o décrits dans le tableau Table 1. A titre d'exemple, le circuit 208 du circuit 600 est configuré pour effectuer un produit point à point, entre le vecteur d'entrée d et une ligne d'une matrice de poids $W_y$. En particulier, les circuits 208 et 212 du circuit 600 sont configurés pour effectuer le produit scalaire entre le vecteur d'entrée d et une ligne d'une matrice de poids $W_y$ sur la base de l'indication de fonctions de lecture $f_u^{(e)}$ et $f_u^{(W)}$ parmi les fonctions g et h. Le circuit de calcul 206 fournit, de manière séquentielle, les composantes y[k] à une première entrée de chacune des portes 602 et 604. A titre d'exemple, le circuit 206 est en outre configuré pour fournir chaque composante y[k] à une première entrée d'un multiplexeur 606.

Les portes 602 et 604 sont en outre configurées pour recevoir, séquentiellement, à une deuxième entrée des composantes $r[k]$ d'un vecteur binaire $r$. La porte 602 est alors, par exemple, configurée pour effectuer, à chaque réception d'une composante $y[k]$, une opération de type AND entre la composante $y[k]$ et la composante $r[k]$. La porte 604 est alors, par exemple, configurée pour effectuer, à chaque réception d'une composante $y[k]$ une opération de type XNOR entre la composante $y[k]$ et la composante $r[k]$. Les valeurs générées par les portes 602 et 604 sont ensuite transmises à un multiplexeur 608 configuré pour sélectionner la sortie de la porte 602, ou la sortie de la porte 604, en fonction d'une fonction de lecture $f_x$. Le multiplexeur 608 est ensuite configuré pour transmettre la valeur sélectionnée à une deuxième entrée du multiplexeur 606. Le multiplexeur 606 est alors configuré pour générer la coordonné de sortie x[k] du vecteur binaire x en sélectionnant la composante $y[k]$, ou la sortie du multiplexeur 608, sur la base d'un signal MODULATION ON. En particulier, les portes 602 et 604 et les multiplexeurs 606 et 608 définissent un exemple d'implémentation du bloc de modulation 500.

Dans un exemple, lorsque l'opération de couche effectuée intègre une modulation correspondant à un masquage, différent du masquage « multiplexage » défini supra, la fonction $f_x$ choisie sera la fonction de Heaviside h. Lorsque l'opération de couche effectuée intègre une modulation correspondant à une modulation binaire, la fonction $f_x$ choisie sera la fonction g.

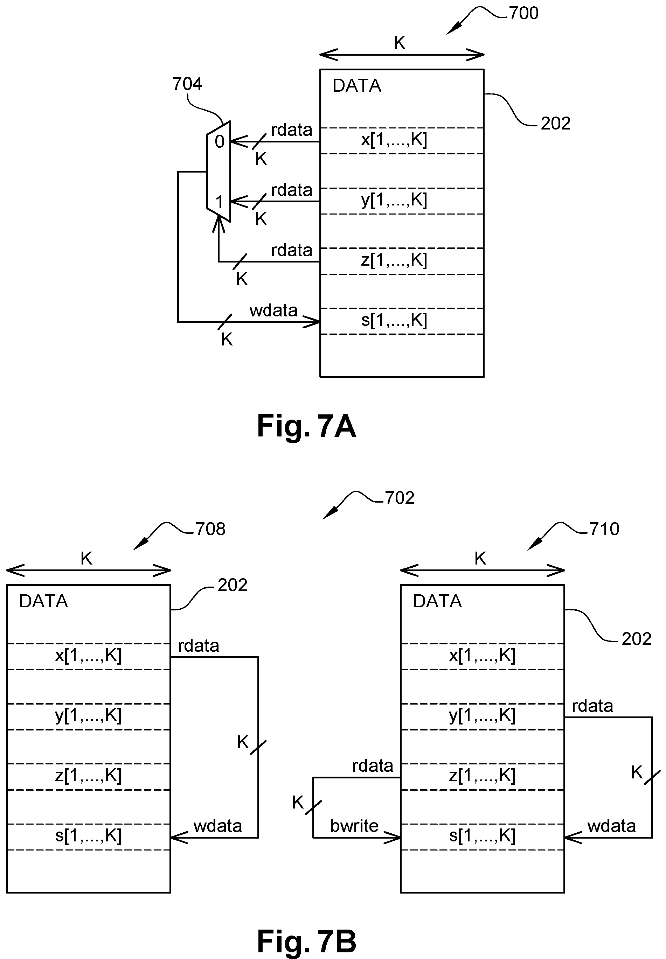

La figure 7A illustre de façon schématique une séquence d'opérations 700 permettant de réaliser un mécanisme de masquage binaire en utilisant éventuellement un circuit de multiplexage 704, mais pouvant également être réalisée sans circuit de multiplexage.

La figure 7B illustre de façon schématique un autre exemple d'une séquence d'opérations 702, à base de lectures et d'écritures d'un circuit mémoire permettant également de réaliser un mécanisme de masquage sans matériel additionnel.

En particulier, les figures 7A et 7B représentent des opérations d'un mécanisme de masquage binaire pouvant être intégré au circuit 200 et/ou 600 et en lien avec l'élément de mémoire 202 décrit en relation avec les figures 2 et/ou 6. Les figures 7A et 7B illustrent des séquences d'opérations 700 ou 702, avantageusement mises en œuvre par le circuit ordonnanceur 216.

A titre d'exemple, le mécanisme de masquage agit sur deux vecteurs de données simultanément, par exemple sur les vecteurs x et y décrits dans le tableau Table 1 et stockés dans la mémoire 202. Le mécanisme de masquage est en outre contrôlé par un vecteur de masquage z, stocké dans la mémoire 202.

A titre d'exemple, un vecteur $s = \bar{z} \cdot x + z \cdot y,$ tel que décrit dans le tableau Table 1, correspond au masquage des vecteurs x et y, contrôlé par le vecteur z. A titre d'exemple, le calcul du vecteur s est réalisé soit selon l'une de la suite d'opérations 700 de la figure 7A, soit selon la suite d'opérations 702 de la figure 7B.

Selon un mode de réalisation illustré en figure 7A, la séquence d'opérations 700 orchestrée par le circuit ordonnanceur 216 est la suivante dans le cas où on utilise un circuit de multiplexage placé en périphérie de l'élément mémoire 202. Le circuit de multiplexage est en pratique composé de K multiplexeurs à 2 entrées chacun piloté par un bit de sélection. Pour commencer, on réalise une lecture dans l'élément mémoire 202 du vecteur x, puis du vecteur y. Les valeurs lues sont placées dans des registres, non représentées, placées en entrée du circuit de multiplexage 704. On effectue ensuite une lecture dans l'élément mémoire 202 du vecteur z. Les valeurs du vecteur z sont utilisées pour commander le circuit de multiplexage 704. Les données présentes en sortie du circuit de multiplexage, suite à cette sélection sur la base du vecteur z, sont ensuite écrites dans l'élément mémoire 202 comme formant le vecteur s.

Selon un autre mode de réalisation alternatif, également illustré sur le principe en figure 7A, la séquence d'opérations 700 orchestrée par le dispositif de commande générale est réalisée sans utilisation d'un multiplexeur. Pour ce faire, on procède à la lecture des vecteurs *x, y* et z en mémoire. Ensuite, selon la composition des moyens de calculs du dispositif de commande générale, on réalise de façon matérielle ou logicielle l'équivalent de la fonction multiplexage décrite ci-dessus. On notera qu'il est éventuellement possible d'alléger potentiellement le nombre de lectures dans la mémoire 202 en commençant par lire le vecteur z, puis en lisant ensuite tout ou partie seulement des vecteurs x et y. Ainsi, si par exemple, tous les bits du vecteur z sont à la même valeur, une seule lecture complète du vecteur x ou y peut être réalisée, l'autre lecture n'étant pas utile. Pour finir, on fait comme précédemment, une écriture du résultat dans l'élément mémoire 202 à l'emplacement de stockage du vecteur s.

Les opérations décrites précédemment se répètent alors, pour chaque valeur *k* entre 1 et *K*. Le circuit ordonnanceur 216 est, par exemple configuré pour commander le stockage de chaque composante du vecteur x dans une mémoire tampon, puis une fois le vecteur généré entièrement, commander son écriture dans la mémoire 202. Dans un autre exemple, le circuit ordonnanceur 216 est configuré pour commander l'écriture de chaque composante du vecteur, une à une et dès leur génération, dans la mémoire 202.

Selon un mode de réalisation, le circuit 704 est configuré pour écrire le vecteur s dans la mémoire 202. Le circuit 704 comprend par exemple un nombre K de multiplexeur en parallèle. A titre d'exemple, dans le cas où le vecteur x n'est pas réutilisé dans un calcul ultérieur, le vecteur s est directement écrit dans la mémoire 202 en remplacement du vecteur x.

Selon un mode de réalisation, le circuit 702 comprend la mémoire 202 configurée pour que des signaux issus de la lecture des données (rdata) et de contrôle d'écriture (bwrite) exécutent un ordonnancement permettant de réaliser le mécanisme de masquage en un nombre réduit de coups d'horloge et à l'aide de signaux standards de contrôle d'une tuile mémoire.

Dans l'exemple illustré par la figure 7B, la mémoire 202 est une mémoire configurée pour la mise en œuvre d'opérations de masquages telle que par exemple décrites plus en détail dans brevet US6075721. Les signaux issus de la lecture des données, de contrôle d'écriture, et des données à écrire, exécutent alors un ordonnancement en deux étapes 708 et 710 successives.

La séquence d'opérations 708 est pilotée par le circuit ordonnanceur 216. Dans cet exemple, la mémoire 202 stocke par exemple les vecteurs *y, x* et z ainsi que le vecteur s correspondant par exemple au tour précédent. Afin de générer le vecteur s pour le tour courant, la mémoire 202 est configurée pour réaliser le masquage $s = y \cdot z + x \cdot \bar{z}$. Pour ce faire, la mémoire 202 est configurée pour lire le vecteur x (rdata) et le copier comme donnée d'écriture (wdata) en le fournissant sur une entrée dite « donnée » de la mémoire 202 à la place du vecteur s du tour précédent.

La séquence d'opérations 710, faisant suite à la séquence 708 comprend la lecture des vecteurs y et z (rdata). Les vecteurs y et z sont par exemple stockés temporairement dans une ou plusieurs mémoires tampon, externe à la matrice 202. Le vecteur z est fourni sur une entrée dite « masque » de la mémoire 202. La mémoire 202 lit alors composante par composante les vecteurs y et z stockés dans les mémoires tampon externes et récrit les composantes *s[k]* dans la mémoire 202 tel que $s[k] = y[k]$ lorsque $z[k] = 1$ et $s[k] = 0$ lorsque $z[k] = 0$. A titre d'exemple, la lecture composante par composante, par la mémoire 202, est réalisée de manière parallèle. Ainsi, suite aux opérations 708 et 710, le vecteur s

**14**

stocké dans la mémoire 202 correspond au masquage $s = y \cdot z + x \cdot \bar{z}$.

Selon un mode de réalisation, le calcul du vecteur s a lieu suite à la génération du vecteur y, ou de manière séquentielle, suite à la génération de chaque composante y[k]. L'écriture de valeurs binaires, décrivant les composantes des vecteurs stockés dans la mémoire 202, s'effectue alors de manière séquentielle, et non de manière parallèle.

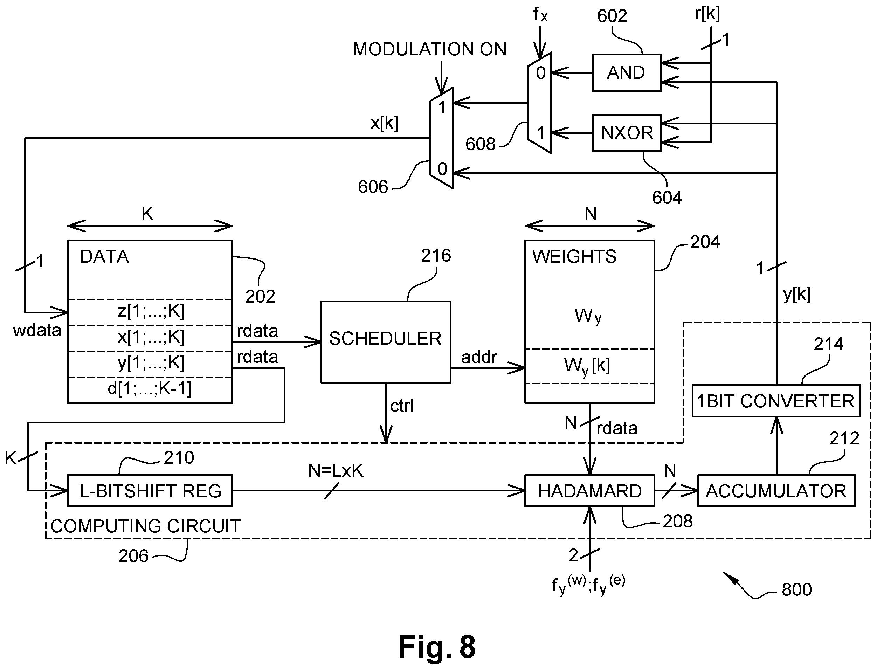

La figure 8 est un schéma par bloc illustrant un exemple d'un circuit 800 d'une couche complètement connectée intégrant un mécanisme de modulation sur un vecteur issu d'un calcul intermédiaire et permettant de réaliser un mécanisme de masquage par une mise à jour conditionnelle du vecteur de sortie, selon un mode de réalisation de la présente description.

Selon un mode de réalisation, le circuit 800 comprend le circuit ordonnanceur 216. A titre d'exemple, le circuit ordonnanceur 216 est configuré pour commander le calcul d'un vecteur s, issu du mécanisme de masquage, tel que $s = \bar{z} \cdot$

$$b\left(f_x\left(b\left(f_y^{(w)}(W_y)f_y^{(e)}(d)\right)\right) \cdot f_x(r)\right) + z \cdot s$$

. A titre d'exemple, le vecteur s représente une opération de couche illustrée en relation avec le tableau Table 1. Dans l'exemple illustré par la figure 7B, le circuit ordonnanceur 216 est configuré pour recevoir le vecteur z et pour, sur la base des valeurs de chaque composante z[k] du vecteur z, commander directement la lecture, ou non, de la k-ième ligne d'une matrice de poids $W_y$, stockée dans la mémoire 204. Ceci permet d'exécuter uniquement les calculs nécessaires à la mise à jour du vecteur s à l'aide des composantes du vecteur x correspondant aux composantes du vecteur z étant nulles, à leurs places correspondantes dans le vecteur s, c'est à dire,

$$b\left(f_x\left(b\left(f_y^{(w)}(W_y)f_y^{(e)}(d)\right)\right) \cdot f_x(r[k])\right)$$

que pour chaque indice k tel que z[k] = 0, on a s[k] =                                         . En particulier, et tel que décrit en relation avec la figure 6, le calcul du vecteur s est réalisé en plusieurs tours de calcul par le circuit 206. Le circuit ordonnanceur 216 est alors configuré pour réduire la latence de calcul et la consommation en énergie du circuit 800 en évitant l'exécution de calculs inutiles.

Dans l'exemple où l'ordonnanceur est configuré pour commander la génération des vecteurs décrits en relation avec le tableau Table 1, la mémoire 202 comprend par exemple, initialement, les vecteurs $s_{t-1}$ et $d_t$. La mémoire 204 comprend, par exemple, les matrices de poids $W_z$, $W_o$ et $W_y$. A titre d'exemple, le vecteur $r_t$ est entièrement calculé par le circuit 206. Le circuit ordonnanceur 216 est alors configuré pour fournir l'indication des fonctions de lecture $f_r^{(W)}$ et $f_r^{(e)}$ au circuit 208 pour la réalisation des produits scalaire entre le vecteur $f_r^{(e)}(d_t)$ et les lignes $f_r^{(W)}(W_z[k])$. Le vecteur $r_t$ est ensuite, par exemple stocké dans la mémoire 202. Le circuit ordonnanceur 216 est en outre configuré pour commander le calcul d'une composante du vecteur $z_t$, par exemple z[1] sur la base des fonctions de lecture $f_z^{(W)}$ et $f_z^{(e)}$. A titre d'exemple, le circuit ordonnanceur 216 est configuré pour fournir l'indication des fonctions de lecture $f_z^{(W)}$ et $f_z^{(e)}$ au circuit 208 pour la réalisation du produit scalaire entre le vecteur $f_z(e)(d_t)$ et la ligne $f_z^{(W)}(W_z[1])$. La composante $z_t[1]$ est ensuite, par exemple, stockée dans la mémoire 202. Dans un autre exemple, les K composantes du vecteur $z_t$ sont calculées et le vecteur $z_t$ est stocké dans la mémoire 202. Le circuit ordonnanceur 216 est en outre configuré pour commander le calcul, par le circuit 206, et en fournissant l'indication des fonctions de lecture $f_y^{(e)}$ et $f_y^{(W)}$, de la composante $y_t[1]$. Le circuit ordonnanceur 216 est ensuite configuré pour activer le signal MODULATION ON afin d'activer le bloc 500. Le bloc 500 est alors configuré pour générer la composante $x_t[1]$ en effectuant une modulation entre $f_x(y_t[1])$ et $f_x(r_t[1])$. La composante $y_t[1]$ n'est alors pas stockée en mémoire 202 suite à son calcul par le circuit 206. La mémoire 202, est alors, par exemple, configuré pour effectuer un masquage, par exemple décrit en relation avec la figure 7A ou 7B. La valeur $z_t[1]$ est lue et la valeur de la composante $s_{t-1}[1]$ est écrasée, dans le cas ou z_t [1] = 0, par la composante $x_t[1]$. La valeur de la composante $s_t[1]$ pour le vecteur $s_t$ courant est alors égale à $x_t[1]$ . Dans le cas où la composante $z_t[1]$ et égale à 1, la composante $s_{t-1}[1]$ n'est pas écrasée et devient la valeur de la composante $s_t[1]$ pour le vecteur $s_t$ courant.

Le circuit ordonnanceur 216 est en outre configuré pour commander le calcul, par le circuit de calcul 206, de la

composante $o_t[1]$ sur la base des fonctions de lecture $f_o^{(W)}$ et $f_o^{(e)}$. Le circuit ordonnanceur 216 est ensuite configuré pour activer le signal MODULATION ON afin d'activer le bloc 500. La composante $o_t[1]$ est, par exemple, directement fournie au bloc de modulation 500 et celui-ci est configuré pour générer la composante *ht[1]* en effectuant une modulation entre $f_h(s_t[1])$ et $f_h(o_t[1])$. La composante $o_t[1]$ n'est alors pas stockée en mémoire 202 suite à son calcul par le circuit 206. Le vecteur $h_t$ est alors mis à jour dans la mémoire 202 suite au stockage de la composante *ht[1]*.

Le circuit 800 effectue alors K-1 autres tours de calcul, afin de calculer toutes les composantes des vecteurs $s_t$ et $h_t$.

Avantageusement, les séquences d'opérations décrites ci-dessus exécutent un ordonnancement permettant de réaliser le mécanisme de masquage en un nombre réduit de coups d'horloge et à l'aide de signaux standards de contrôle d'une tuile mémoire par le circuit ordonnanceur 216. De plus, des données intermédiaires sont directement utilisé, par exemple pour des opérations de modulations, sans être préalablement stockée ce qui permet un gain de surface et de temps.

Un avantage des modes de réalisation décrits est qu'ils permettent d'effectuer des opérations de couche proche mémoire, et en particulier des opérations intermédiaires en variant les arithmétiques utilisées, entre chaque couche et entre chaque opération, pour les matrices de poids et vecteurs manipulés.

Un avantage d'une implémentation proche mémoire réside également dans le fait que les signaux de contrôle canoniques du plan mémoire peuvent être utilisés de façon efficiente pour tout ou partie des variantes décrites ci-dessus.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit comprenant :

   - un premier élément de mémoire (202) configuré pour stocker une première donnée *(e,x,y,s,o,u,r)* ;
   - un deuxième élément de mémoire (204) configuré pour stocker une première matrice de poids ($W_y$) en association d'une première couche d'un réseau de neurones binaires artificiel ;
   - un circuit de calcul (206) configuré pour :

     a) recevoir la première donnée et la k-ème ligne ($W_y[k]$), de la première matrice de poids ;
     b) recevoir un premier signal de commande, indiquant la nature de chacune des première et deuxième fonctions de lecture ($f_y^{(W)}$, $f_y^{(e)}$), parmi au moins des première et deuxième fonctions de référence *(g, h),* les première et deuxième fonctions de référence étant chacune associée à une arithmétique à deux valeurs ;
     c) générer un premier vecteur ($f_y^{(W)}(W_y[k])$) en appliquant la première fonction de lecture ($f_y^{(W)}$) à la k-ème ligne de la première matrice de poids et un deuxième vecteur ($f_y^{(e)}(e)$) en appliquant la deuxième fonction de lecture ($f_y^{(e)}$) à la première donnée ; et
     d) générer une *k*-ième composante ($y[k]$) d'un premier vecteur de sortie ($y$) sur la base des premier et deuxième vecteurs.

2. Circuit selon la revendication 1, dans lequel la première fonction de référence est à valeurs dans {-1,1} et la deuxième fonction de référence est à valeurs dans {0,1}.

3. Circuit selon la revendication 1 ou 2, configuré pour, suite à la génération de la *k*-ième composante ($y[k]$) du premier vecteur de sortie ($y$), commander le stockage de la *k*-ième composante dans le premier élément de mémoire (202).

4. Circuit selon l'une quelconque des revendications 1 à 3, comprenant en outre :

- une première porte logique (602) configurée pour appliquer une opération de type AND entre la *k*-ième composante *(y[k])* du premier vecteur de sortie *(y),* transmise par le circuit de calcul (206), et une composante (*r* [*k*]) d'un vecteur binaire (*r*) ;
- une deuxième porte logique (604) configurée pour appliquer une opération de type XNOR entre la *k*-ième composante (*y*[*k*]) du premier vecteur, transmise par le circuit de calcul (206), et la composante (*r*[*k*]) du vecteur binaire (*r*) ;
- un premier multiplexeur (608) configuré pour sélectionner la sortie de la première porte logique (602), ou la sortie de la deuxième porte logique (604), sur la base d'un signal de commande, indiquant la nature d'une troisième fonction de lecture (*f*$_x$) parmi les première et deuxième fonctions de référence (*g, h*) *;*
- un deuxième multiplexeur (606) configuré pour générer une *k*-ième composante (*x*[*k*]) d'un deuxième vecteur de sortie (*x*) en sélectionnant la *k*-ième composante (*y*[*k*]) du premier vecteur, fournie par le circuit de calcul, ou la sortie du premier multiplexeur, sur la base d'un signal de modulation.

5. Circuit selon l'une quelconque des revendications 1 à 4, comprenant en outre un circuit ordonnanceur (216) configuré pour :

   - recevoir une composante d'un vecteur stocké dans le premier élément mémoire (202) ; et
   - sur la base de la valeur de la composante, commander la lecture, dans le deuxième élément mémoire, de la *k*-ème ligne (*W*$_y$[k]) de la première matrice de poids.

6. Circuit selon l'une quelconque des revendications 1 à 5, dans lequel le circuit de calcul (206) comprend :

   - un nombre *N* de circuits multiplieurs (208_1, 208_N) chacun configurés pour recevoir la première et la deuxième fonction de lecture et chacun configurés pour générer un scalaire de sortie sur la base d'une composante d'un vecteur et d'une composante d'une matrice de poids ;
   - un circuit accumulateur (212) configuré pour additionner les scalaires de sortie fournis par la pluralité de circuits multiplieurs ; et
   - un convertisseur (214) configuré pour convertir la valeur générée par le circuit accumulateur en une valeur binaire.

7. Circuit selon la revendication 6, dans lequel l'accumulateur (212) comprend un arbre additionneur (500), comprenant une pluralité de circuits de décalage (502) et configuré pour générer un scalaire, correspondant au produit scalaire entre les premier et deuxième vecteurs, augmenté d'un gain en puissance de 2.

8. Circuit selon l'une quelconque des revendications 1 à 7, dans lequel, la première donnée est de longueur *N, N* étant un nombre entier, et est stockée de manière contiguë par vecteurs de longueurs *K, K* étant un diviseur de la valeur *N,* et dans lequel la *k*-ème ligne (*W*$_y$[k])*,* de la première matrice est de longueur *N* et dans lequel le circuit de calcul (206) comprend un nombre **L = N/K** de registres à décalage (210) reliés au premier élément de mémoire (202) et est configuré pour, suite à la réception d'une suite de vecteurs de la première donnée, convertir ladite première donnée en un vecteur de taille **N,** par concaténation de vecteurs de taille **K,** dans lequel les registres à décalage (210) sont, par exemple, en outre configuré pour effectuer la concaténation de la première donnée de taille *K* avec une suite de *N - K* bits chacun égaux à 1, ou à 0.

9. Circuit selon la revendication 8, dans lequel chacun des circuits multiplieurs (208_1, 208_N)comprend une porte logique de type NXOR et/ou AND configurée pour multiplier une composante de la première donnée et un élément de la première matrice de poids associé à la première couche.

10. Circuit selon la revendication 5, dans lequel le premier élément de mémoire (202) est en outre configurée pour stocker un vecteur de masquage (*z*), le circuit ordonnanceur (216) étant configuré pour :

    - si la *k*-ième composante du vecteur de masquage est égale à 0, commander le stockage de la *k*-ième composante de la première donnée comme *k*-ième composante du premier vecteur de sortie ; et
    - si la *k*-ième composante du vecteur de masquage est égale à 0, commander l'exécution des étapes a) à c).

11. Circuit selon la revendication 10, dans lequel le premier élément mémoire (202) est une mémoire configurée pour la mise en œuvre d'opérations de masquages.

12. Circuit selon l'une quelconque des revendications 1 à 11, dans lequel, le deuxième élément (204) de mémoire stocke en outre une troisième matrice de poids associée à une deuxième couche du réseau de neurones, et dans lequel le circuit de calcul (206) est en outre configuré pour :

- sélectionner, suite à la réception d'un deuxième signal de commande, des cinquième et sixième fonctions de lecture, parmi les première et une deuxième fonctions de référence ;
- générer un cinquième vecteur en appliquant la cinquième fonction de lecture à une ligne, ou colonne, de la troisième matrice de poids et un sixième vecteur en appliquant la sixième fonction de lecture sur un vecteur de sortie d'une couche précédente, stockée dans le premier élément de mémoire (202) ;
- générer une troisième valeur de sortie sur la base des cinquième et sixième vecteurs.

13. Circuit selon l'une quelconque des revendications 1 à 12, dans lequel la première fonction de référence (*g*) est définie par $g : u \rightarrow u$ et la deuxième fonction de référence *(h)* est définie par $h : u \rightarrow 2u - 1$.

14. Procédé comprenant :

- la fourniture d'une première donnée (***e,x, y, s, o, u, r***) stockée dans un premier élément de mémoire (202) d'un circuit (200, 600, 700, 702) et de la *k*-ème ligne ($W_y$[k]) d'une première matrice de poids associée à une couche d'un réseau de neurones artificiel binaire à un premier circuit de calcul (206) du circuit ;
- la fourniture d'une indication, par l'intermédiaire d'un signal de commande, de la nature d'une première et d'une deuxième fonctions de lecture ( $f_y^{(W)}$ , $f_y^{(e)}$ ), parmi une première et une deuxième fonction de référence *(g, h)* ;

- la génération, par le premier circuit de calcul, d'un premier vecteur ( $f_y^{(W)}\big(W_y[k]\big)$ ) en appliquant la première fonction ( $f_y^{(e)}$ ) à la k-ième ligne de la matrice de poids et d'un deuxième vecteur ( $f_y^{(e)}(e)$ ) en appliquant la deuxième fonction ( $f_y^{(W)}$ ) sur la première donnée,
- la génération d'une k-ième composante (y[k]) d'un premier vecteur de sortie (y) sur la base des premier et deuxième vecteurs,

les première et deuxième fonctions de référence chacune associées à arithmétique à deux valeurs.

15. Procédé selon la revendication 14, dans lequel le premier circuit de calcul (206) comprend une pluralité de circuits multiplieurs (208_1, 208_N)et un accumulateur (212) configurés pour générer un scalaire en effectuant un produit scalaire entre les premier et deuxième vecteurs, dans lequel, le premier circuit de calcul (206) comprend, par exemple, un convertisseur (214) configuré pour convertir le scalaire en une valeur binaire.

16. Procédé selon la revendications 14 ou 15, comprenant en outre :

- la lecture, par un deuxième circuit de calcul (704) de la valeur d'une première composante de la première donnée *(x[k]),* de la première valeur de sortie (*y*[k]) et d'une première valeur de masquage (*z*[k]), stockées dans le premier élément mémoire (202) ; et
- la commande, sur la base de la première valeur de masquage et par le deuxième circuit de calcul, de l'écriture d'une première valeur masquée (*s*[k]), dans le premier élément mémoire, correspondant soit à la première composante de la première donnée, soit à la k-ième composante du premier vecteur de sortie.

17. Procédé selon la revendication 16, dans lequel l'écriture de la première valeur masquée comprend :

- la suppression de la première composante de la première donnée ; et
- l'écriture de la première valeur masquée à l'adresse de la première composante de la première donnée dans le premier élément mémoire.

18. Procédé selon la revendication 16 ou 17, comprenant en outre, après l'écriture de la première valeur masquée :

- la génération d'une k+1-ième composante de sortie (y[k+ **1])** du premier vecteur de sortie et son stockage dans le premier élément mémoire (202) ;

- la lecture, par le deuxième circuit de calcul de la valeur d'une k+1-ième composante de la première donnée ($x[k + 1]$), de la k+1-ième composante ($y[k + 1]$) du premier vecteur de sortie et d'une deuxième valeur de masquage ($z[k + 1]$), stockées dans le premier élément mémoire (202) ; et

- la commande, sur la base de la deuxième valeur de masquage et par le deuxième circuit de calcul, de l'écriture d'une deuxième valeur masquée ($s[k+1]$), dans le premier élément mémoire, correspondant soit à la k+1_ième composante de la première donnée, soit à la k+1_ième composante du vecteur de sortie.

**Fig. 1**

**Fig. 2**

**Fig. 3**

**Fig. 4A**

**Fig. 4B**

$$e[1] \quad W_y[k][1]$$
$$e[2]$$
$$W_y[k][2]$$
$$e[N] \quad W_y[k][N]$$

100

$$\sum_{n=1}^{N} W_y[k][n]e[n]$$

102

0 ⌐ 1

y[k]

r[k] → MODULATION → x[k]

500

# Fig. 5

**Fig. 6**

**Fig. 7A**

**Fig. 7B**

Fig. 8

Europäisches
Patentamt

European
Patent Office

Office européen
des brevets

**RAPPORT DE RECHERCHE EUROPEENNE**

Numéro de la demande

EP 25 17 1162

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | GAO JIABAO ET AL: "FCA-BNN: Flexible and Configurable Accelerator for Binarized Neural Networks on FPGA", IEICE TRANSACTIONS ON INFORMATION AND SYSTEMS, vol. E104.D, no. 8, 1 août 2021 (2021-08-01), pages 1367-1377, XP093222081, JP ISSN: 0916-8532, DOI: 10.1587/transinf.2021EDP7054 | 1-3,5-9, 12-15 | INV. G06N3/0495 G06N3/063 G11C11/54 |
| Y | * abrégé; figures 1-6 * * page 1368, colonne 2, ligne 5 - page 1373, colonne 2, ligne 40 * ----- | 4,10,11, 16-18 | |
| Y | RYU SUNGJU ET AL: "Binaryware: A High-Performance Digital Hardware Accelerator for Binary Neural Networks", IEEE TRANSACTIONS ON VERY LARGE SCALE INTEGRATION (VLSI) SYSTEMS, IEEE SERVICE CENTER, PISCATAWAY, NJ, USA, vol. 31, no. 12, 1 décembre 2023 (2023-12-01), pages 2137-2141, XP011953946, ISSN: 1063-8210, DOI: 10.1109/TVLSI.2023.3324834 [extrait le 2023-10-31] * abrégé * * page 2138, colonne 2, ligne 26 - ligne 48 * ----- -/-- | 4 | DOMAINES TECHNIQUES RECHERCHES (IPC) G06N G11C |

Le présent rapport a été établi pour toutes les revendications

| Lieu de la recherche | Date d'achèvement de la recherche | Examinateur |
|---|---|---|
| La Haye | 18 août 2025 | Rousset, Antoine |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

.................................................................
& : membre de la même famille, document correspondant

EPO FORM 1503 03.82 (P04C02)

# EP 4 641 448 A1

Europäisches
Patentamt

European
Patent Office

Office européen
des brevets

**RAPPORT DE RECHERCHE EUROPEENNE**

Numéro de la demande

EP 25 17 1162

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | PING XUE ET AL: "IR2Net: Information Restriction and Information Recovery for Accurate Binary Neural Networks", ARXIV.ORG, CORNELL UNIVERSITY LIBRARY, 201 OLIN LIBRARY CORNELL UNIVERSITY ITHACA, NY 14853, 6 octobre 2022 (2022-10-06), XP091335762, * abrégé; figure 4 * * page 4, colonne 1, ligne 1 - page 5, colonne 2, ligne 16 * ----- | 10,11, 16-18 | |
| A | CHUNYU YUAN ET AL: "A comprehensive review of Binary Neural Network", ARXIV.ORG, CORNELL UNIVERSITY LIBRARY, 201 OLIN LIBRARY CORNELL UNIVERSITY ITHACA, NY 14853, 11 octobre 2021 (2021-10-11), XP091075479, * abrégé; figure 11 * * page 14, ligne 1 - page 26, ligne 12 * ----- | 1-18 | |
| A | KNAG PHIL C ET AL: "A 617-TOPS/W All-Digital Binary Neural Network Accelerator in 10-nm FinFET CMOS", IEEE JOURNAL OF SOLID-STATE CIRCUITS, IEEE, USA, vol. 56, no. 4, 3 décembre 2020 (2020-12-03), pages 1082-1092, XP011846509, ISSN: 0018-9200, DOI: 10.1109/JSSC.2020.3038616 [extrait le 2021-03-25] * abrégé; figures 4-6, 9, 10 * * page 1084, colonne 1, ligne 11 - page 1087, colonne 2, ligne 1 * ----- | 1-18 | **DOMAINES TECHNIQUES RECHERCHES (IPC)** |

Le présent rapport a été établi pour toutes les revendications

| Lieu de la recherche | Date d'achèvement de la recherche | Examinateur |
|---|---|---|
| La Haye | 18 août 2025 | Rousset, Antoine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
......................................................................................
& : membre de la même famille, document correspondant

EPO FORM 1503 03.82 (P04C02)

page 2 de 2

29

## RÉFÉRENCES CITÉES DANS LA DESCRIPTION

**Documents brevets cités dans la description**

- US 6075721 A